# EUROPÄISCHE PATENTSCHRIFT

(11) **EP 0 757 825 B1**
(45) Veröffentlichungstag und Bekanntmachung des Hinweises auf die Patenterteilung: **01.07.1998**
(21) Anmeldenummer: 95918616.4
(22) Anmeldetag: 27.04.1995
(51) Int. Cl.: G06K 19/077, H05K 5/02

(54) **MEHRTEILIGES DICHTES GEHÄUSE**
MULTIPART SEALED HOUSING
BOITIER ETANCHE EN PLUSIEURS PARTIES

(30) Priorität: 29.04.1994 DE 4415066
(43) Veröffentlichungstag der Anmeldung: 12.02.1997
(73) Patentinhaber: Diehl Stiftung & Co., 90478 Nürnberg (DE)
(72) Erfinder: HORNIG, Wolfgang, D-90542 Eckental (DE)
(74) Vertreter: Hofmann, Gerhard, Dipl.-Ing. Patentassessor
(86) Internationale Anmeldenummer: EP9501599
(87) Internationale Veröffentlichungsnummer: WO9530207

(56) Entgegenhaltungen:
- EP-A- 0 546 680
- DE-A- 4 115 998
- US-A- 5 061 845
- PATENT ABSTRACTS OF JAPAN vol. 15 no. 2 (M-1065) ,7.Januar 1991 & JP,A,02 255394 (MITSUBISHU ELECTRIC CORP.) 16.Oktober 1990,

## Beschreibung

Die Erfindung bezieht sich auf ein mehrteiliges dichtes Gehäuse zur Aufnahme elektrischer Bauteile, wobei das Gehäuse aus Rahmen, Boden, Deckel sowie einer an einer Rahmenseite eingesetzten Steckerleiste besteht, wobei mit Hilfe der letzteren das Gehäuse durch Einschieben in elektrische und mechanische Verbindung mit einem Gegenstecker in einem elektrischen Gerät bringbar ist.

Derartige Gehäuse, aus Kunststoff gefertigt, sind seit einigen Jahren unter der technischen Bezeichnung PCMCIA-Karten auf dem Markt unter der Normung der Personal Computer Memory Card International Association (PCMCIA). Diese Karten haben zwischen 35-bis 88poligen Buchsen bzw. Steckern, wobei 68polige Steckverbinder mengenmäßig eine besondere Bedeutung erlangt haben. Diese Gehäuse nehmen in ihrem Inneren elektronische Schaltungen, insbesondere Speicherschaltungen, auf, welche für PC-Speicher, Fax- oder Modem-Steuerungen dienen. Aber auch Festplatten-Laufwerke sind bereits in solche Gehäuse eingesetzt worden. Deren besondere Vorteile liegen darin, daß die in ihm angeordneten Baugruppen zum einen gegen Außeneinflüsse geschützt sind und zum anderen durch Einbringen in Einschübe von elektrischen Geräten leicht auswechselbar sind. Damit sind beispielsweise für PC's oder Faxgeräte aber auch für Maschinensteuerungen große Erweiterungsmöglichkeiten von deren technischen Fähigkeiten gegeben, insbesondere auch eine leichtere Anpaßbarkeit an die verschiedenen Kundenwünsche.

In Zukunft wird die Zahl der elektrischen Baugruppen, die in einem solchen Gehäuse angeordnet werden sollen, größer, mit der Folge, daß zum einen die Packungsdichte und zum anderen die abgegebene Wärme dieser Bauteile immer mehr zunimmt. Die Packungsdichte kann erhöht werden durch sogenannte Chip-On-Board-Technik, welche jedoch voraussetzt, daß derartige Gehäuse hermetisch dicht gemacht werden, da die Bauteile im Gehäuse nicht mehr selbst gekapselt sind. Durch die erhöhte Packungsdichte steigt andererseits die Wärmeabgabe pro Volumeneinheit.

Kunststoffgehäuse sind nicht hermetisch dicht und für derartige Zukunftsanwendungen nicht mehr ausreichend. Außerdem ist ihre Wärmeabgabe nach außen gering. Metallgehäuse sind daher ein Mittel der Wahl, um diesen zukünftigen Anforderungen gerecht zu werden. Gehäuse aus Edelstahl, welche sich für derartige Zwecke zunächst anbieten, sind jedoch höheren Anforderungen an die Wärmeleitfähigkeit nicht mehr ausreichend gewachsen.

Durch die Patent Abstracts of Japan, vol. 15 no. 2 (M-1065), entsprechend JP-A-2 255 394 vom 07.01.91 ist es bereits bekannt, bei einer IC-Card einen Rahmen aus Aluminiumlegierung vorzusehen, und auf diesem je eine Metallplatte als Boden und als Deckel aufzubringen. Durch eine Steckerleiste im Rahmen wird das Gehäuse abgeschlossen.

Die Erfindung hat es sich daher zum Ziel gesetzt, ein Gehäuse für derartige Anwendungen vorzuschlagen, welches die Möglichkeit einer hermetischen Dichtung bietet bei gleichzeitig hoher Wärmeleitfähigkeit und guter Festigkeit des Gehäuses.

Zur Lösung dieser Aufgabe schlägt die Erfindung die in Anspruch 1 gekennzeichneten Merkmale vor. Die Erfindung geht von der Überlegung aus, daß optimale Eigenschaften eines solchen Gehäuses dadurch gegeben sind, wenn seine beiden technischen Hauptanforderungen durch Verwendung für den jeweils vorgesehenen Zweck optimierter Materialien erfüllt werden. Mit anderen Worten, jene Teile des Gehäuses, bei welchen es auf die Abstrahlung der Wärme ankommt, sind aus einem Material mit hohen Wärmeleitfähigkeitsvermögen, nämlich einer Kupferlegierung, ausgebildet, wohingegen jene Teile des Gehäuses, welche die Baugruppen in seinem Inneren elektrisch mit der Außenwelt in Verbindung bringen, nämlich die Steckerleisten, aus einem anderen Material gebildet sind, wodurch eine gute Abdichtung, insbesondere eine hermetische Abdichtung ermöglicht wird. Außerdem erfolgt eine Trennung der Funktionen Abdichtung und Aufnahme der mechanischen Kräfte.

Im Sinne der Erfindung ist es gleichgültig, ob die Steckerleiste an ihrer Gehäuseaußenseite Buchsen oder Steckerteile aufweist. Aus mechanischen Gründen ist jedoch die Anordnung von Buchsen bevorzugt, da beim Zusammenstecken mit dem Gegenstecker-Teil die mechanische Beanspruchung geringer ist.

Als bevorzugte weitere Ausbildung der Erfindung ist vorgesehen, daß das zweite Kupfermaterial aus einer druckeinglasungsfähigen Legierung besteht, wie z. B. CuNi9Sn8, CuCrZr.

Nachfolgend soll die Erfindung anhand der Zeichnung noch näher erläutert werden.

Es zeigen:
- Figur 1: eine Ansicht eines Gehäuses gemäß der Erfindung,
- Figur 2: die Ansicht einer Steckerleiste von oben,
- Figur 3: die Ansicht der Steckerleiste in Ansicht "A" in Figur 2,
- Figur 4: die Ansicht einer hermetisch dichten Steckerleiste, wenn zwei Steckerleisten im Gehäuse vorgesehen sind,
- Figur 5: die Ansicht der Steckerleiste von Figur 4 in Pfeilrichtung "B",
- Figur 6: ein Rahmenteil für die Aufnahme einer einzigen Steckerleiste,
- Figur 7: ein Rahmenteil zur Aufnahme von zwei Steckerleisten,
- Figur 8: das Rahmenteil mit einer eingesetzten Steckerleiste,
- Figur 9: das Rahmenteil mit zwei eingesetzten Steckerleisten,
- Figur 9a: in vergrößerter Darstellung die Verbindung der beiden Steckerleisten von Figur 9,
- Figur 10: einen Schnitt entlang der Linie X-X in Figur 3, wenn eine Keramik-Stekkerleiste verwendet ist.

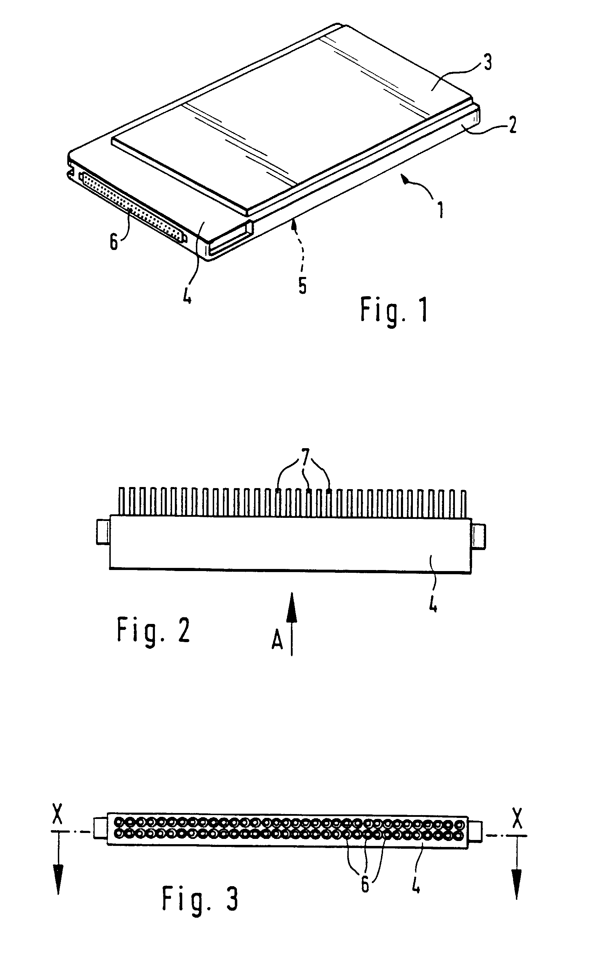

In Figur 1 ist in perspektivischer Darstellung ein solches Gehäuse 1 dargestellt, welches aus einem Rahmen 2, einem Deckel 3, einer Steckerleiste 4 und einem nicht sichtbaren Bodenteil 5 besteht. In diesem Gehäuse sind, in der Zeichnung nicht sichtbar, auf einer Leiterplatte elektronische Baugruppen angeordnet, welche in elektrischer Verbindung mit der Steckerleiste 4, insbesondere den dort angeordneten Buchsen 6 stehen.

Rahmen 2, Deckel 3 und Boden 5 sind von der Materialauswahl im Hinblick auf hohe Wärmeleitfähigkeit optimiert. Diese drei Bauteile könnten aus Reinstkupfer sein, wenn es auf beste Wärmeleitfähigkeit und nicht auf hohe Festigkeit ankommt. Erfindungsgemäß verwendet werden jedoch Kupferlegierungen mit guter Wärmeleitfähigkeit und hoher Festigkeit. Hier können handelsübliche Legierungen wie CuFe2P oder CuNiSi aber auch andere als Leitmaterial für elektrische Bauteile geeignete Kupferlegierungen verwendet werden.

Die Steckerleiste hat die Aufgabe, als Gehäuseteil zum einen die mechanische Beanspruchung mit dem nicht dargestellten Gegensteckerteil eines elektrischen Gerätes aufzunehmen und zum anderen eine dichte, vorzugsweise jedoch eine hermetisch dichte elektrische Durchführung zu ermöglichen. Für eine solche Steckerleiste ist daher ein für diese Aufgabe optimiertes Material auszuwählen. Dies können entweder Kupferlegierungen mit besonderen Eigenschaften oder Keramiken mit hoher Isolationswirkung sein. Geeignete Kupferlegierungen, die die gewünschten Eigenschaften aufweisen, sind solche, die druckeinglasungsfähig sind. Durch die Druckeinglasung ist eine hermetisch dichte Durchführung von metallischen Leitern durch eine Gehäusewand möglich. Legierungen mit derartigen Eigenschaften sind beispielsweise CuNi9Sn8, CuCrZr, CuNiSiCr, wie sie im Handel erhältlich sind.

In Figur 2 ist eine Steckerleiste 4 in einer Ansicht von oben dargestellt. Figur 3 zeigt eine Ansicht der Steckerleiste in Pfeilrichtung "A" der Fig. 2. Man erkennt, daß an der gehäuseäußeren Seite der Steckerleiste Buchsen 6 angeordnet sind, wohingegen auf der gehäuseinneren Seite metallische Stecker 7 herausragen, die im Inneren der Steckerleiste elektrisch mit den Buchsen verbunden sind.

Bei der beschriebenen Steckerleiste, in diesem Falle aus Keramik Al₂O₃, sind 68 Buchsen und ebensoviele Stecker vorgesehen. Die Anordnung der Buchsen 6 und der Stecker 7 in der Steckerleiste 4 wird durch Verlöten vorgenommen, wodurch eine hermetische Dichtheit der Metalldurchführung ermöglicht wird. Das Verfahren, wie diese Verlötung erfolgt, ist jedoch nicht Gegenstand der Erfindung.

In jenen Fällen, bei denen die Beanspruchung der Steckerleiste 4 durch häufiges Ein- und Ausstecken in ein Gerät besonders hoch ist, kann es zweckmäßig sein, die Steckerleiste an der Gehäuseaußenseite speziell für hohe mechanische Beanspruchung auszulegen, ihr jedoch die Funktion der Dichtung zu nehmen. In einem solchen Falle ist es zweckmäßig, im Gehäuse eine zweite Steckerleiste 8 vorzusehen, welche die Funktion der hermetischen Abdichtung vornimmt. Zu diesem Zwecke sind in der Steckerleiste, welche aus einem der vorgenannten druckeinglasungsfähigen Materialien besteht, eine gleiche Zahl von Metalldurchführungen 9 vorgesehen, welche hermetisch dicht in der Steckerleiste 8 angeordnet sind. Die Druckeinglasung der Metalldurchführungen 9 in der Steckerleiste 8 erfolgt in üblicher Weise und ist ebenfalls nicht Gegenstand der Erfindung.

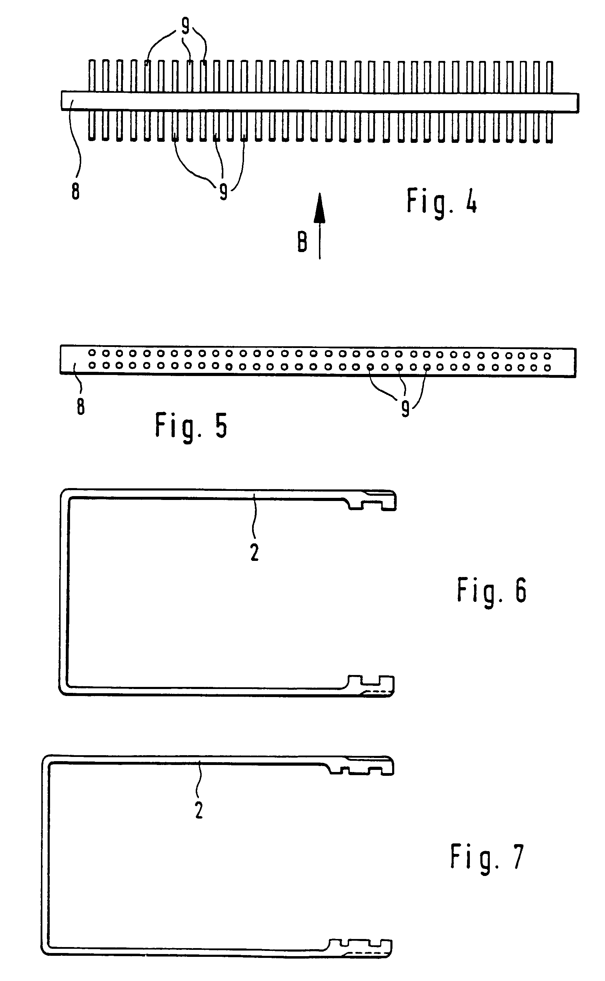

In Figur 6 ist ein Rahmenteil 2 vorgesehen, welches zur Aufnahme einer einzelnen Steckerleiste vorbereitet ist, wenn diese Steckerleiste gleichzeitig die hermetische Abdichtung ermöglicht, wie dies an der Steckerleiste anhand der Figuren 2 und 3 beschrieben wurde. In Figur 7 ist ein Rahmenteil 2 beschrieben, welches zur Aufnahme zweier Steckerleisten geeignet ist, nämlich in der gehäuseinneren Position eine Steckerleiste 8 und in der gehäuseäußeren Position eine Steckerleiste 4, wobei die letztere aus Kunststoff besteht und keine dichte Metalldurchführung aufweist. Derartige Steckerleisten sind handelsüblich und bedürfen keiner näheren Erklärung.

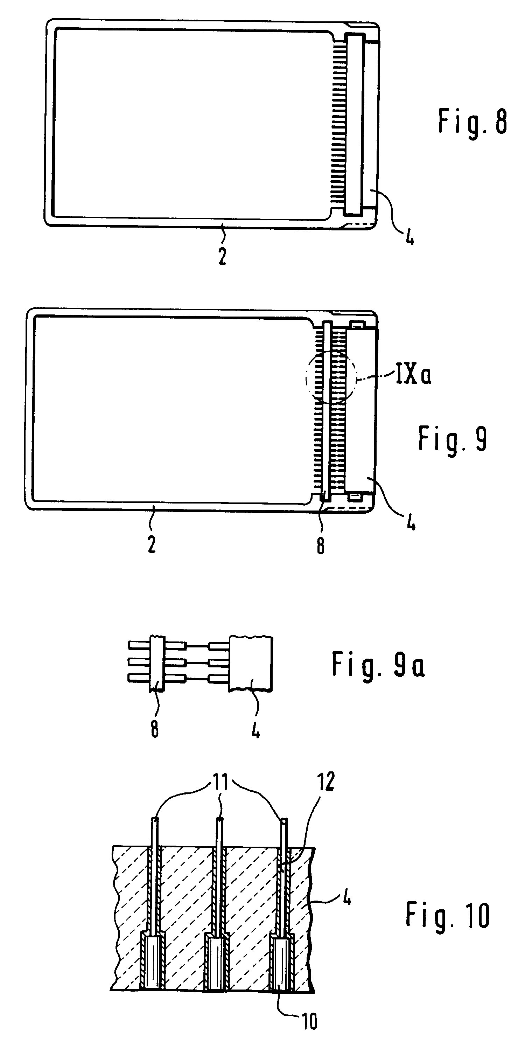

In Figur 8 ist eine Steckerleiste 4, eingesetzt in das Rahmenteil 2, dargestellt. In Figur 9 sind Steckerleisten 4 und 8 in das Rahmenteil eingesetzt. In Figur 9a ist in vergrößertem Maßstab gezeichnet, daß die Stecker der Steckerleisten 4 und 8 durch Drähte miteinander verbunden sind.

Wie bereits erläutert, kann die Steckerleiste 4 aus keramischem Material bestehen. Dieses Material hat den Vorteil, daß es ein guter Isolator ist und damit Isolationsprobleme zwischen den verschiedenen Metalldurchführungen nicht auftreten. Damit jedoch diese Metalldurchführungen in den Bohrungen der Steckerleiste hermetisch dicht eingebracht werden können, ist es erforderlich, daß diese Bohrungen metallisiert sind, so daß ein Einlöten von Buchse und Stecker in der Bohrung möglich ist. In Figur 10 ist in einem Schnitt entlang der Linie X-X der Figur 3 dargestellt, wie eine derartige Durchführung aussieht. Die Innenseiten der Bohrungen 12 im Keramikkörper 4 sind metallisiert, die Buchse 10, an welche ein als Stecker dienender Metalldraht 11 angeordnet ist, wird in die Bohrung 12 eingeschoben und dort durch Löten hermetisch dicht verschlossen. Damit die Steckerleiste 4 aus Keramik mit dem übrigen Gehäuse, d.h. dem Rahmen 2, dem Boden 5 und dem Deckel 3 hermetisch dicht verbunden werden kann, müssen die entsprechenden Kontaktflächen der Stekkerleiste 4 ebenfalls metallisiert sein. Dann ist eine hermetisch dichte Verbindung zwischen diesen Bauteilen vermittels Löten oder Laser-Schweißen möglich. Die Metallisierung des Keramikkörpers kann beispielsweise mit Wolfram oder Molybdän erfolgen.

## Patentansprüche

1. Mehrteiliges dichtes Gehäuse zur Aufnahme elektrischer Bauteile, wobei das Gehäuse aus Rahmen, Boden, Deckel sowie einer an einer Rahmenseite eingesetzten Steckerleiste besteht, wobei mit Hilfe der letzteren das Gehäuse durch Einschieben in elektrische und mechanische Verbindung mit einem Gegenstecker in einem elektrischen Gerät bringbar ist, wobei das Gehäuse (I) aus wenigstens zwei verschiedenen Materialien besteht, von denen zumindest eines aus Metall ist,
dadurch gekennzeichnet,
daß Rahmen (2), Boden (5) und Deckel (3) aus einer Kupferlegierung mit guter Wärmeleitfähigkeit und hoher Festigkeit bestehen und daß das Gehäuse (1) hermetisch dicht ist und zwei hintereinander angeordnete Steckerleisten (4, 8) aufweist, von denen die gehäuseinnere Steckerleiste (8) aus einem zweiten druckeinglasungsfähigen Kupfermaterial oder einer Keramik, wie z. B. Al₂O₃ hoher Reinheit besteht, hermetisch dichte Metallführungen (9) aufweist und elektrisch mit einer gehäuseäußeren Steckerleiste (4) in Verbindung steht, welch letztere aus Kunststoff besteht, keine Dichtungseigenschaften besitzt und die Außenstecker (6) trägt, die mit dem Gegenstecker in Wirkverbindung treten.

2. Gehäuse nach Anspruch 1,
dadurch gekennzeichnet,
daß die Steckerleiste (8) aus Keramik an ihren an dem Gehäuse (1), d.h. Boden, Deckel, Rahmen, anliegenden Flächen metallisiert ist.

3. Gehäuse nach Anspruch 1,
dadurch gekennzeichnet,
daß das zweite Kupfermaterial aus einer druckeinglasungsfähigen Legierung besteht, wie z. B. CuNi9Sn8, CuCrZr.

## Claims

1. Multi-part, sealed housing for accommodating electrical components, the housing consisting of framework, base, and cover as well as a plug board inserted at one side of the framework, whereby by means of this plug board the housing can be electrically and mechanically connected by insertion with a mating plug in an electrical apparatus, whereby the housing (I) consists of at least two different materials, at least one of which is made of metal,
characterized in that,
the framework (2), base (5) and cover (3) are made of a high-grade copper alloy with good thermal conductivity, and in that the housing (1) is hermetically sealed and has two plug boards (4, 8) arranged one behind the other, of which the plug board (8) inside the housing is made of a second, copper material which is capable of being pressure-glazed or of a ceramic, such as for instance Al₂O₃ of high purity, has hermetically sealed metal guides (9) and is electrically connected with a plug board (4) on the outside of the housing, this latter plug board (4) being made of plastic, having no sealing properties and bearing the external plugs (6) which are operatively connected with the mating plug.

2. Housing according to Claim 1,
characterized in that
the plug board (8) made of ceramic is metallized on its surfaces adjacent to the housing (1), i.e. base, cover, framework.

3. Housing according to Claim 1,
characterized in that
the second copper material consists of an alloy which is capable of being pressure-glazed, such as for instance CuNi9Sn8, CuCrZr.

## Revendications

1. Boîtier étanche en plusieurs parties, destiné à recevoir des composants électriques, le boîtier étant constitué d'un cadre, d'un fond, d'un couvercle ainsi que d'une barrette de connecteur insérée sur un côté cadre, le boîtier pouvant être placé, à l'aide de cette barrette de connecteur, par une insertion, en liaison électrique et mécanique avec un connecteur conjugué se trouvant dans un appareil électrique, le boîtier (I) étant constitué d'au moins deux matériaux différents, dont au moins l'un est du métal,
caractérisé en ce que
le cadre (2), le fond (5) et le couvercle (3) sont constitués d'un alliage de cuivre ayant une bonne conductibilité thermique et une résistance élevée, et en ce que le boîtier (1) est hermétiquement étanche et présente deux barrettes de connecteur (4, 8) disposées l'une derrière l'autre, dont la barrette de connecteur (8), située à l'intérieur du boîtier, est constituée d'un deuxième matériau cuivreux apte à être vitrifié par impression, ou bien d'une céramique, telle que par exemple Al₂O₃ de pureté élevée, présente des guidages métalliques (9) hermétiquement étanches et est reliée électriquement à une barrette de connecteur (4) extérieure au boîtier, cette barrette de connecteur étant réalisée en matière plastique, n'ayant aucune propriété d'étanchéité et portant les connecteurs extérieur (6) qui sont reliés fonctionnellement aux connecteurs conjugués.

2. Boîtier selon la revendication 1, caractérisé en ce que la barrette de connecteur (8) est réalisée en céramique sur ses surfaces appuyant sur le boîtier (1), c'est-à-dire le fond, le couvercle, le cadre.

3. Boîtier selon la revendication 1, caractérisé en ce que le deuxième matériau cuivreux est constitué d'un alliage susceptible d'être vitrifié par impression, tel que par exemple CuNi₉Sn₈, CuCrZr.
